(19) Europäisches Patentamt / European Patent Office / Office européen des brevets

(11) **EP 3 790 193 B1**

(12) **EUROPEAN PATENT SPECIFICATION**

(45) Date of publication and mention
of the grant of the patent:
**25.02.2026 Bulletin 2026/09**

(21) Application number: **19195870.1**

(22) Date of filing: **06.09.2019**

(51) International Patent Classification (IPC):
$H03M\ 1/50^{(2006.01)}$  $H03M\ 7/16^{(2006.01)}$
$H03K\ 3/03^{(2006.01)}$  $H03L\ 7/085^{(2006.01)}$

(52) Cooperative Patent Classification (CPC):
**H03K 3/0315; H03M 1/50; H03M 7/165; H03L 7/085**

(54) **APPARATUSES AND METHODS FOR GENERATING TIME RESOLUTION FOR ELECTRONIC DEVICES**

EINRICHTUNGEN UND VERFAHREN ZUR ERZEUGUNG VON ZEITAUFLÖSUNG FÜR ELEKTRONISCHE VORRICHTUNGEN

APPAREILS ET PROCÉDÉS DE GÉNÉRATION DE RÉSOLUTION TEMPORELLE POUR DISPOSITIFS ÉLECTRONIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**10.03.2021 Bulletin 2021/10**

(73) Proprietor: **Huawei Technologies Co., Ltd.**
**Shenzhen, Guangdong 518129 (CN)**

(72) Inventors:
• UNNIKRISHNAN, Vishnu
Aalto (FI)
• JÄRVINEN, Okko
FI-00076 Aalto (FI)
• WAQAS, Siddiqui
FI-00076 Aalto Aalto (FI)
• KOSUNEN, Marko
00910 Helsinki (FI)
• STADIUS, Kari
FI-00076 Aalto Aalto (FI)
• RYYNÄNEN, Jussi
01400 Vantaa (FI)

(74) Representative: **Maiwald GmbH**
**Engineering**
**Elisenhof**
**Elisenstrasse 3**
**80335 München (DE)**

(56) References cited:
**US-A1- 2012 154 187    US-A1- 2012 319 883**

• **SATOSHI ITO ET AL: "Stochastic TDC architecture with self-calibration", CIRCUITS AND SYSTEMS (APCCAS), 2010 IEEE ASIA PACIFIC CONFERENCE ON, IEEE, 6 December 2010 (2010-12-06), pages 1027 - 1030, XP031875726, ISBN: 978-1-4244-7454-7, DOI: 10.1109/APCCAS.2010.5774740**
• **ZANUSO M ET AL: "Time-to-digital converter with 3-ps resolution and digital linearization algorithm", ESSCIRC, 2010 PROCEEDINGS OF THE, IEEE, PISCATAWAY, NJ, USA, 14 September 2010 (2010-09-14), pages 262 - 265, XP031788535, ISBN: 978-1-4244-6662-7**
• **UNNIKRISHNAN VISHNU ET AL: "Mitigation of Sampling Errors in VCO-Based ADCs", IEEE TRANSACTIONS ON CIRCUITS AND SYSTEMS I: REGULAR PAPERS, IEEE, US, vol. 64, no. 7, 1 July 2017 (2017-07-01), pages 1730 - 1739, XP011654611, ISSN: 1549-8328, [retrieved on 20170623], DOI: 10.1109/TCSI.2017.2670058**

EP 3 790 193 B1

**Description**

TECHNICAL FIELD

Generally, the following description relates to the field of electronic devices. More specifically, the following description relates to apparatuses and methods for generating a time resolution for an electronic device with resilience to mismatch-induced sampling errors.

BACKGROUND

High resolution timing is an important aspect in many modern integrated circuit applications. One example of an application with a need for high resolution timing is modem data communication networks. These networks involve use of high-speed and high-resolution analog-to-digital converters and time-to-digital converters. An example of such modem data communication network is so called 5G, wherein high bandwidth and latency requirements cause a need for high resolution timing.

US 2012 154187 A1 describes methods and systems for thermometer coded line that is configured to convert a time interval to a digital code for subsequent processing in order to output a value representative of said time interval. A digital peak detector is coupled to receive output from the thermometer coded line, the detector operating for correction of an undesired code of said digital code in order to ensure a valid output of said value.

SATOSHI ITO ET AL: "Stochastic TDC architecture with self-calibration" CIRCUITS AND SYSTEMS (APCCAS), 2010 IEEE ASIA PACIFIC CONFERENCE ON, IEEE, 6 December 2010 (2010-12-06), pages 1027-1030, XP031875726 describes techniques for stochastic TDC architecture with self-calibration.

US 2012/319883 A1 describes time-to-digital converter are provided, comprising a delay stage matrix and a measurement circuit.

ZANUSO M ET AL: "Time-to-digital converter with 3-ps resolution and digital linearization algorithm", ESSCIRC, 2010 PROCEEDINGS OF THE, IEEE, PISCATAWAY, NJ, USA, 14 September 2010 (2010-09-14), pages 262-265, XP031788535, ISBN: 978-1-4244-6662-7 describes time-to-digital converter with 3-ps resolution and digital linearization algorithm.

UNNIKRISHNAN VISHNU ET AL: "Mitigation of Sampling Errors in VCO-Based ADCs", IEEE TRANSACTIONS ON CIRCUITS AND SYSTEMS I: REGULAR PAPERS, IEEE, US, vol. 64, no. 7, 1 July 2017 (2017-07-01), pages 1730-1739, XP011654611, ISSN: 1549-8328, DOI: 10.1109/TCSI.2017.2670058 describes mitigation of sampling errors in VCO-based ADCs.

The design of analog-to-digital converters using time-domain circuit techniques involves converting the analog input signal into a time domain signal using a voltage-to-time converter. The resulting dime-domain signal is then sampled and quantized into a digital signal using a time-to-digital converter. The resolution of a time-domain analog-to-digital converter is determined by the gain of the voltage-to-time conversion together with the resolution of the time-to-digital conversion.

Conventionally the time resolution has been depending on the delay of inverters used in the converter. Thus, the delay has been at least partially technology dependent. In order to improve the time resolution beyond the inverter delay solutions such as Vernier time-to-digital converters and pulse shrinking converters have been introduced.

However, as higher bandwidths and shorter latencies are continuously demanded there is a need to improved apparatuses and methods for generating improved time resolution.

One solution to this problem is to use grid arrangements, such as cyclic coupled ring oscillators or similar. Cyclic coupled ring oscillator refers to an arrangement where a number of ring oscillators (M) are coupled in a cyclic fashion, forming a ring of rings. When properly designed, the individual ring oscillators establish a phase relationship among themselves such that $2 \times N \times M$ phase steps uniformly distributed between 0 and $2\pi$ can be extracted from the structure. The resulting time step between temporally adjacent phase steps is approximately 1/M of the inverter delay. Thus, a sub-gate-delay resolution is achieved. When such an arrangement is used in a ring oscillator TDC architecture instead of employing a regular ring oscillator, a technology-independent and arbitrarily small time step can be achieved without compromising the conversion time.

A grid arrangement, such as cyclic couple ring oscillator, achieves an arbitrarily small sub-gate-delay phase quantization step. When a cyclic couple ring oscillator based data converter is implemented in a deeply-scaled semiconductor technology, the phase quantization step approaches a picosecond or even shorter. It is known that the wire-delay dominates the gate-delay in a highly-scaled semiconductor technology. Hence the delay mismatch from wiring may easily exceed the phase quantization step of the cyclic couple ring oscillator even in a carefully laid out design. This results in erroneous sampling of the phase signal. A set of non-ideal circuit conditions that contributes to the delay mismatch in the phase signal that can lead to erroneous sampling may occur. This includes the mismatch in low-to-high and high-to-low propagation delays, rise and fall delays, low and high drive strengths, drive strengths among the cyclic couple ring oscillator nodes, load among the cyclic couple ring oscillator nodes, wiring delay among the nodes, and the clock skew among the flip-flops of the register. The net effect of the mismatch can be modeled by a delay mismatch among the nodes of the phase signal. When the magnitude of the mismatch approaches the phase quantization step of the cyclic couple ring oscillator, which is highly likely when designing cyclic couple ring oscillator based converters in deeply-scaled technologies, the sampled phase signal can have errors that cause large errors at the converter output thereby degrading the performance.

## SUMMARY

The invention is defined by the independent claims. Possible developments are defined by the dependent claims. The claims disclose an apparatus and a method for encoding a sampled phase signal. The apparatus receives an input from a sub-gate-delay resolution arrangement and has a processing circuitry configured to invert selectively a set of bits in a sampled matrix sampled at a sampling instance based on a first predefined reference node of the sub-gate-delay resolution arrangement in order to provide a unary code. A unary code means a code where every bit in the code has equal weight. The unary code is then compressed and used in unfolding a mapping based on the compressed unary code using a value of a chosen bit. Then the apparatus provides an output based on said unfolding. As a result the arrangement provides a possibility to use a sub-gate-delay for several different applications.

In an aspect, an apparatus for encoding a sampled phase signal such as defined in independent claim 1 is disclosed. The apparatus comprises a sampling instance configured to receive an input from a sub-gate-delay resolution arrangement. The apparatus further comprises a processing circuitry configured to invert selectively a set of bits in a sampled matrix sampled at a sampling instance based on a first predefined reference node of the sub-gate-delay resolution arrangement in order to provide a unary code; compress the unary code; and unfold a mapping based on the compressed unary code using a value of a chosen bit. The apparatus further comprises an output configured to provide an output based on said unfolding.

In particular, the apparatus may include a cyclic coupled ring oscillator (CCRO).

The sampled matrix may be a matrix obtained by sampling the logic values at the nodes of a CCRO at the sampling instance. The processing circuitry may be configured to invert selectively a set of bits in the matrix based on a predefined reference node of the sub-gate-delay resolution arrangement. According to an implementation, this inversion operation, provides a unary code with redundant non-unique mapping to the phase of the CCRO. In other words, the codes used for the phase in the range 0 to 180 degrees may, for instance, also be used for the phase in the range 180 to 360 degrees as well. The unary code may be compressed by computing the sum of non-zero bits in the code. The resulting sum, which could be seen as an example of the mapping referred to in the previous paragraph, may be unfolded by using a value of a chosen bit to obtain a non-redundant unique mapping between the code and the phase of the CCRO. Unfolding is performed by either considering the sum of non-zero bits or its inverse depending on the value of the reference bit. Here, inverse of the sum refers to the difference between the sum and the maximum possible value for the sum.

A benefit of the arrangement is that it encodes the sampled phase of a cyclic-coupled ring oscillator in resilient manner thereby eliminating or reducing the impact of sampling errors caused due to the delay mismatch between the phase taps of the oscillator, accomplishes the following objectives that improve the performance of a data converter employing a CCRO as a quantizer. Furthermore, it helps the design of high-performance high-bandwidth data converters with a technology-independent sub-gate-delay resolution in highly-scaled semiconductor technologies where wire delay mismatch dominates gate delay mismatch. It further provides an error-resilient encoding method for the sampled phase of a cyclic coupled ring oscillator so that the delay mismatch inherent to a design in a deeply-scaled process does not significantly degrade the performance of the converter. Furthermore, the encoder is entirely digital and can be fully designed with CAD tools available for digital design thereby generating a reduced design time and cost as well as an improved portability of the design.

The processing circuitry is further configured, when compressing the unary code, to count the number of ones in the unary code. The ones-counter counts the sum of all ones in the output and provides the sum for use in the error mitigation, wherein the sum can be used in selection of a chosen bit.

The value of a chosen bit is selected from a result of counting the number of ones in the unary code. It is beneficial to use the sum counted by the ones counter in an error mitigation.

In an implementation the apparatus comprises a second processing circuitry and a second output configured perform the same tasks with, the first processing circuitry and first output in parallel with at least two different predefined reference nodes for providing at least two outputs from one input. It is beneficial to compute two different values so that a better representative value can be chosen from computations based on two different taps.

In an implementation the apparatus is configured to select a second predefined reference, wherein the second predefined reference is non-contiguous to the first predefined reference such that the temporal distance between the transitions at the first and the second reference nodes is maximized in the sub-gate-delay resolution arrangement. In particular, the first and second references may be spaced apart, i.e. the second reference may be located at a predetermined temporal distance from the first reference in the sub-gate-delay resolution arrangement. When the references are located spaced apart in the oscillator arrangement the accuracy of the arrangement is improved.

In an implementation the first and second processing circuitry are configured to estimate the temporal position of the transiting phase taps at the sampling instance. The estimation of the temporal position of the transiting phase taps at sampling instance improve the selection of the correct tap.

In an implementation the first and second processing circuitry are configured to select a correct output from the at least two outputs based on the estimation. When there are two options to choose the accuracy of the arrangement can be improved because of possibility to discard an option that is inaccurate.

The apparatus further comprises a logic and is further configured to provide a histogram of the output to the logic and to detect if an appropriate inversion pattern specific to the mode of oscillation is applied. The use of histogram and logic for choosing appropriate inversion pattern improves the accuracy of the arrangement by facilitating choosing of an appropriate inversion pattern.

In an implementation the apparatus is further configured to select a suitable inversion pattern by detecting the mode of oscillation. The use of mode of oscillation when choosing appropriate inversion pattern improves the accuracy of the arrangement by facilitating choosing of an appropriate inversion pattern.

In an aspect a method for encoding a sampled phase signal such as defined in independent claim 7 is disclosed. The method comprises receiving an input from a sub-gate-delay resolution arrangement at a sampling instance; inverting selectively a set of bits in a sampled matrix sampled at a sampling instance based on a first predefined reference node of the sub-gate-delay resolution arrangement in order to provide a unary code; compressing the unary code; unfolding a mapping based on the compressed unary code using a value of a chosen bit; and providing an output based on said unfolding. A benefit of the method is that it encodes the sampled phase of a cyclic-coupled ring oscillator in resilient manner thereby eliminating or reducing the impact of sampling errors caused due to the delay mismatch between the phase taps of the oscillator, accomplishes the following objectives that improve the performance of a data converter employing a CCRO as a quantizer. Furthermore, it helps the design of high-performance high-bandwidth data converters with a technology-independent sub-gate-delay resolution in highly-scaled semiconductor technologies where wire delay mismatch dominates gate delay mismatch. It further provides an error-resilient encoding method for the sampled phase of a cyclic coupled ring oscillator so that the delay mismatch inherent to a design in a deeply-scaled process does not significantly degrade the performance of the converter. Furthermore, the encoder is entirely digital and can be fully designed with CAD tools available for digital design thereby providing a reduced design time and cost as well as an improved portability of the design.

Compressing the unary code comprises counting the number of ones in the unary code. The ones-counter counts the sum of all ones in the output and provides the sum for use in the error mitigation, wherein the sum can be used in selection of a chosen bit.

The value of a chosen bit is selected from a result of counting the number of ones in the unary code. It is beneficial to use the sum counted by the ones counter in an error mitigation.

In an implementation the method is performed at least twice in parallel with at least two different predefined reference nodes for providing at least two outputs from one input. It is beneficial to compute two different values so that a better representative value can be chosen from computations based on two different taps.

In an implementation the method further comprises selecting a second predefined reference so that are located in spaced apart in the sub-gate-delay resolution arrangement. When the references are located spaced apart in the oscillator arrangement the accuracy of the arrangement is improved.

In an implementation the method further comprises estimating the temporal position of the transiting phase taps at the sampling instance. The estimation of the temporal position of the transiting phase taps at sampling instance improve the selection of the correct tap.

In an implementation selecting a correct output from the at least two outputs based on the estimation. When there are two options to choose the accuracy of the arrangement can be improved because of possibility to discard an option that is inaccurate.

The method comprises providing a histogram of the output to a logic and detecting if an appropriate inversion pattern specific to the mode of oscillation is applied. The use of histogram and logic for choosing appropriate inversion pattern improves the accuracy of the arrangement by facilitating choosing of an appropriate inversion pattern.

In an implementation the method further comprises selecting a suitable inversion pattern by detecting the mode of oscillation. The use of mode of oscillation when choosing appropriate inversion pattern improves the accuracy of the arrangement by facilitating choosing of an appropriate inversion pattern.

In an implementation the method further comprises selecting mode of oscillation. It is beneficial to choose the mode of oscillation so that the intended application and overall configuration can be taken into account.

In an aspect a computer program comprising computer program code such as defined in independent claim 14 is disclosed. The computer program code is configured to cause performing a method as described above, when the computer program code is executed in a computing device. It is beneficial to implement the method for the arrangement as an executable computer program so that the parameters can be easily changed when needed.

The foregoing and other objects are achieved by the subject matter of the independent claims. Further implementation forms are apparent from the dependent claims, the description and the figures.

The principles discussed in the present description can be implemented in hardware and/or software.

BRIEF DESCRIPTION OF THE DRAWINGS

Further example embodiments will be described with respect to the following figures, wherein:

Fig. 1 shows an example of a schematic diagram illustrating an analog to digital converter;

Fig. 2 shows an example of a regular ring oscillator 200;

Fig. 3 shows an example of a cyclic coupled ring oscillator is shown;

Fig. 4 shows an example of a TDC using a cyclic coupled ring oscillator;

Fig. 5 shows sources of delay mismatch associated with sampling of the phase signal;

Fig. 6 shows an example of the error in the sampled phase signal caused due to the delay mismatch;

Fig. 7 shows an example, wherein the states of a $5 \times 3$ CCRO for a mode where $\psi = 120°$ are shown;

Fig. 8 shows an example of a sampling method;

Fig. 9 shows examples of inversion patterns;

Fig. 10 shows an example of states after applying the inversion;

Fig. 11 shows an example of an encoding arrangement; and

Fig. 12 shows the error suppression capability of the proposed scheme;

In the various figures, identical reference signs will be used for identical or at least functionally equivalent features.

DETAILED DESCRIPTION OF THE EMBODIMENTS

In the following description, reference is made to the accompanying drawings, which form part of the disclosure, and in which are shown, by way of illustration, specific aspects in which the present apparatuses and methods may be placed. It is understood that other aspects may be utilized and structural or logical changes may be made without departing from the scope of the claims. Thus, the following detailed description, therefore, is not to be taken in a limiting sense.

For instance, it is understood that a disclosure in connection with a described method may also hold true for a corresponding device or system configured to perform the method and vice versa. For example, if a specific method step is described, a corresponding device may include a unit to perform the described method step, even if such unit is not explicitly described or illustrated in the figures. Further, it is understood that the features of the various exemplary aspects described herein may be combined with each other, unless specifically noted otherwise.

In the following specification cyclic coupled ring oscillator is used and explained as an example, however, the arrangements and methods with resilience to mismatch-induced sampling errors can be used with other grid-like arrangements.

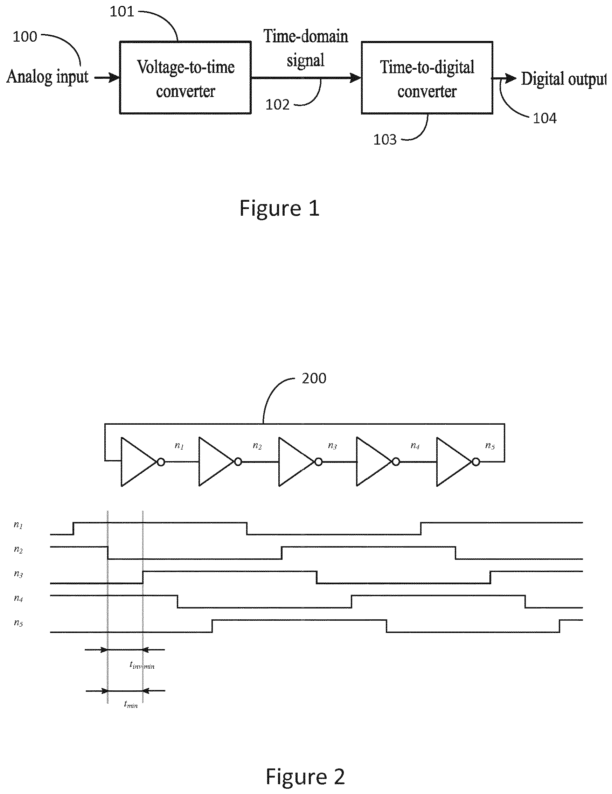

In figure 1 a basic implementation of an analog-to-digital converter is shown. The example analog-to-digital converter may be used as a basis for an embodiment for the described arrangements and in particular for the apparatus for generating a time resolution, i.e. for performing data conversion with a predefined time resolution. The analog-to-digital converter of figure 1 receives an analog input 100 at a voltage-to-time converter 101. The received analog input, usually voltage-represented signal, 100 is then converted into a time-domain signal 102 using a voltage-to-time converter (VTC) 101. The resulting time-domain signal 102 is then sampled and quantized into a digital signal using a time-to-digital converter (TDC) 103 for providing a digital output 104. The resolution of a time-domain ADC is determined by the gain of the voltage-to-time conversion together with the resolution of the time-to-digital conversion. The arrangement described below in detail helps improving the resolution of the time-to-digital conversion thereby also improving the resolution of the analog-to-digital conversion.

Figure 2 shows an example of a regular ring oscillator 200. A regular ring oscillator divides its phase into 2N steps where N is the number of inverters in the ring. Hence, the time resolution that is created is still in steps of inverter delays. The regular ring oscillator 200 is a regular ring oscillator with 5 inverters and the resulting phase interpolation are shown in the figure below the ring oscillator 200. The minimum inverter delay for the specific load conditions is assumed to be $t_{inv-min}$. Note that the minimum time step possible in the circuit, $t_{min}$, is the same as $t_{inv-min}$.

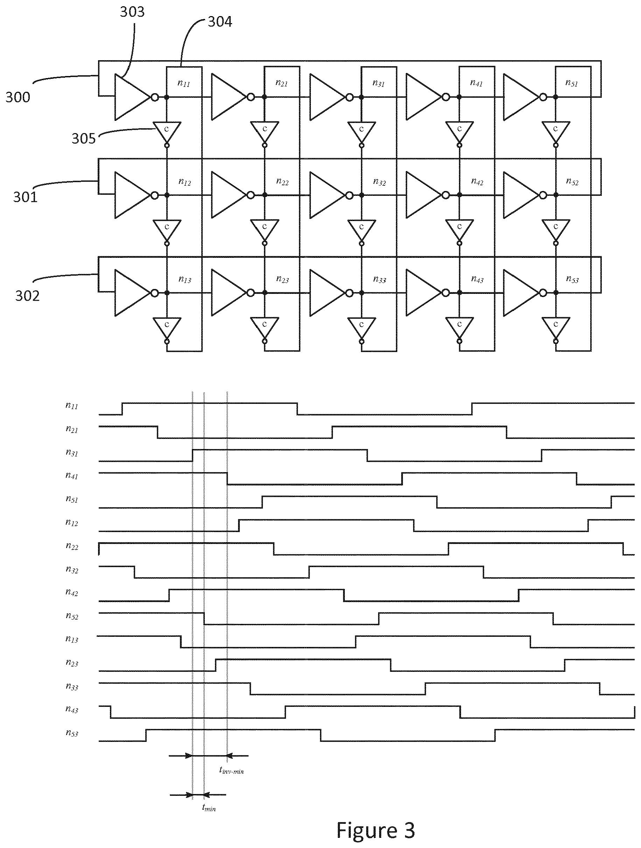

In figure 3 an example of a cyclic coupled ring oscillator is shown. The number of ring oscillators and of inverters in each ring is for explicative purposes only. However, the invention can be implemented by a ring oscillator arrangement with an arbitrary number of stages and an arbitrary number of inverters in each stage. Further, the number of coupling inverters may also not be limited to that shown in this embodiment. In the example shown, the number of coupling inverters is the same as the number of inverters in the cyclic coupled ring oscillator, however, as mentioned this is only one possible example. The cyclic coupled ring oscillator comprises three regular 5-stage ring oscillators 300 - 302. The cyclic coupled ring oscillator has five inverters 303 in each regular ring oscillator, $N = 5$; $M = 3$. The newly introduced coupling inverters 305 are marked with c. The coupling inverters are arranged into a ring 304 for coupling the regular ring oscillators 300 - 302 to each other. The coupling inverters 305 are usually designed to have relatively weak drive strength compared to regular inverters 303.

The 5-stage oscillators 300 - 302 are cyclically coupled with coupling inverters which in turn forms a set of vertical ring oscillators. When the coupled oscillators oscillate in the desired mode of oscillation, wherein each possible mode corresponds to a certain distinct phase relationship between the 5-stage horizontal oscillators, the desired phase interpolation as shown in Fig. 3 below the cyclic coupled ring oscillator is achieved. There are usually several different modes that provide the desired phase interpolation and hence it is easy to design the structure to ensure a desired mode of oscillation. It can be seen from Fig. 3 that the minimal time step present in the circuit, $t_{min}$ is now $1/M$, which less than the minimum inverter delay $t_{inv-min}$. Thus, the desired sub-gate-delay resolution is achieved.

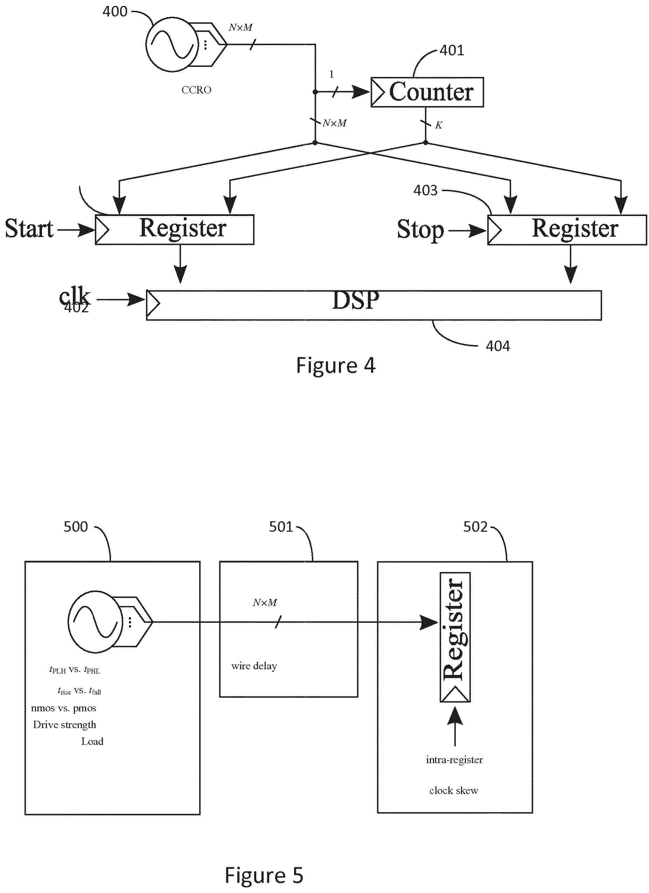

Figure 4 shows an example of a TDC using a cyclic coupled ring oscillator 400. A cyclic coupled ring oscillator 400 achieves an arbitrarily small sub-gate-delay phase quantization step. When a cyclic coupled ring oscillator based data converter (TDC or ADC) is implemented in a deeply-scaled semiconductor technology, the phase quantization step approaches a picosecond or even shorter. As shown in Fig. 4, the phase output of the cyclic coupled ring oscillator needs to be sampled by registers 402 and 403. The sampled phase of the oscillator is then encoded into a number inside the digital signal processor block 404 in order to generate a digital output sample. Note that the wire-delay dominates the gate-delay in a highly-scaled semiconductor technology. Hence the delay mismatch from wiring may easily exceed the phase quantization step of the cyclic coupled ring oscillator even in a carefully laid out design. The example of figure 4 additionally shows a counter 401 that can be used for counting integer cycles of oscillations of the cyclic coupled ring oscillator.

Figure 5 illustrates sources of delay mismatch associated with sampling of the phase signal. When the delay mismatch exceeds the phase quantization step of the cyclic coupled ring oscillator the sampling of the phase signal will be erroneous. A set of non-ideal circuit conditions that contributes to the delay mismatch in the phase signal that can lead to erroneous sampling are illustrated in Fig. 5. This includes the mismatch in low-to-high and high-to-low propagation delays, rise and fall delays, low and high drive strengths, drive strengths among the cyclic coupled ring oscillator nodes, load among the cyclic coupled ring oscillator nodes, wiring delay among the nodes, and the clock skew among the flip-flops of the register. The net effect of the mismatch can be modeled by a delay mismatch among the nodes of the phase signal. When the magnitude of the mismatch approaches the phase quantization step of the cyclic coupled ring oscillator, which is highly likely when designing cyclic coupled ring oscillator based converters in deeply-scaled technologies, the sampled phase signal can have errors that cause large errors at the converter output thereby degrading the performance.

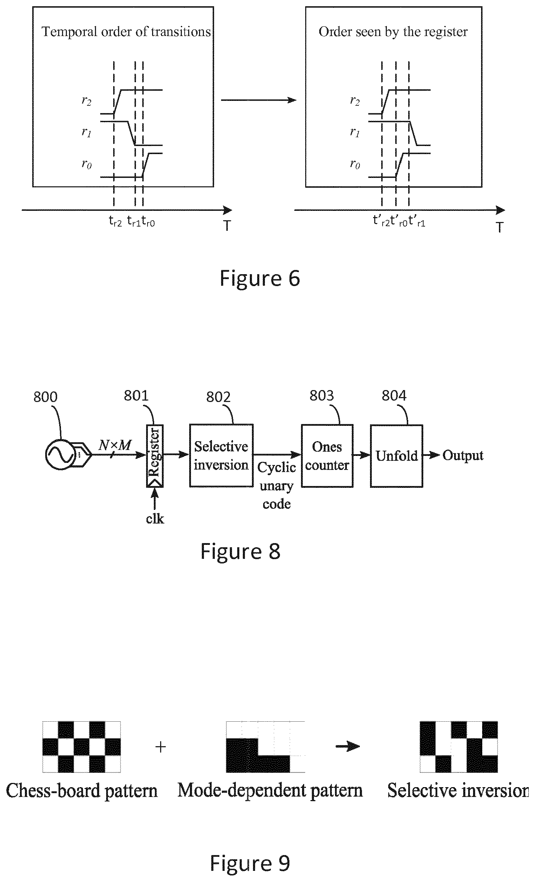

Figure 6 illustrates an example of the error in the sampled phase signal caused due to the delay mismatch. The example shows the error with reordering of the transitions in the ring as seen by the sampling register. In figure 6 $r_2$ through $r_0$ are nodes in a cyclic coupled ring oscillator with temporally adjacent phase increments. Also in this case the number of nodes is set to 3 for explicative purposes. However, it should be clear that the number of nodes nay be arbitrary. The nodes in a cyclic coupled ring oscillator with temporally adjacent phase transitions are not usually spatially adjacent. As seen in figure 6, the temporal order of transitions in the multi-phase output of a cyclic coupled ring oscillator can be seen in a different order by the register inputs due to the delay mismatch in the phase signal. In other words, due to the delay mismatch, the time at which transitions happen in the multi-phase output of a cyclic coupled ring oscillator (CCRO) can have a different temporal order in the register. For instance, in this example the time order of the transitions in the multi-phase output of the CCRO is $t_{r2} < t_{r1} < t_{r0}$, while the time order of the same transitions seen by the register is $t'_{r2} < t'_{r0} < t'_{r1}$. Such a reordering can cause errors in the sampled phase leading to large conversion errors. The number of temporally adjacent nodes (phase taps) over which the reordering spreads and the complexity of reordering patterns depend on the extent of delay mismatch in relation to the phase step of the cyclic coupled ring oscillator as well as complexity of the pattern of delay mismatch.

For finite N and $M$, there are finite ways in which the phases at multiple nodes in a CCRO can be related under locked condition if we assume that the drive strength of the coupling inverter is weaker than that of the main inverter. Each horizontal ring oscillator oscillates similar to the case of a regular ring oscillator. When the oscillators are locked, the constant phase difference between the adjacent nodes in the horizontal oscillator can be expressed as

$$\theta = \pi + \pi/N$$

and the phase difference between adjacent vertical nodes is given by

$$\psi = n \ (2\pi/M),$$

where $0 < n < M$.

Each value of $n$ corresponds to a certain mode of oscillation. Since there are $M-1$ solutions for $\psi$, there are $M-1$ unique modes of oscillations possible in theory. There are, however, a small number of stable modes for a practical design, among which some has maximal phase resolution with $2 \times N \times M$ distinct phase steps. A CCRO can be designed to oscillate in a stable mode with maximal phase resolution by choosing proper values for $N$, $M$, and the ratio of the drive strengths of the main inverter and the coupling inverter.

A certain node, for example, $n_{11}$, is henceforth considered as the reference node by setting its phase to zero. Then, the relative phases at every node of the cyclic coupled ring oscillator can be calculated using $\theta$ and $\psi$ for any desired mode. Hence, the possible states of a cyclic coupled ring oscillator, each defined by the set of the Boolean states of all the nodes in the cyclic coupled ring oscillator, can be predicted for all modes.

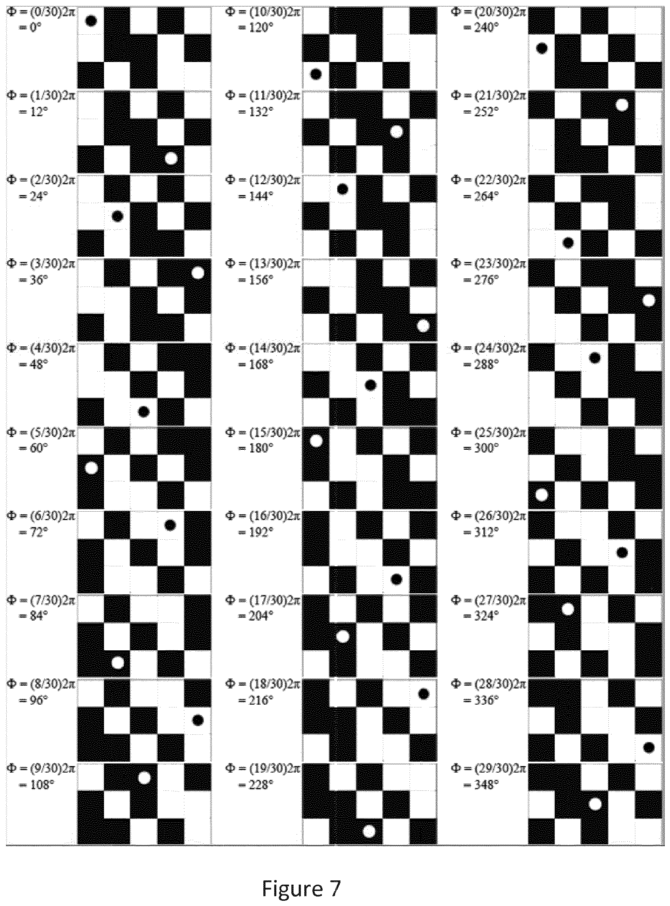

Figure 7 illustrates an example, wherein the states of a 5×3 CCRO for a mode where $\psi = 120°$ are shown. There are $2 \times N \times M = 30$ distinct states possible that corresponds to the distinct phase steps as indicated. Each square represents the state of a node in the CCRO where a black square indicates logic low and a white square indicates logic high. Clearly, the way the logic states are indicated is purely conventional. Accordingly, a logic low may be also indicated with a white square and a logic high may also be indicated with a black square. In general, any mapping capable or representing a pattern of binary states can be used instead of the one depicted in figure 7. The square with a circle highlights the defining node for the respective state, i.e., the node that switched compared to the previous state. It can be observed that the temporally adjacent transitions in a CCRO do not occur typically at nodes that are in spatial proximity, unlike the case of a regular ring oscillator.

When the signals within the multi-phase output of the CCRO are delayed unevenly leading to temporal reordering of transitions as seen by the sampling register, the sampled output deviates from the set of the finite valid patterns. Note the large amount of redundancy present in the CCRO code ($2 \times N \times M$ vs. $2^{N \times M}$ possible patterns), which can be utilized for error correction. A beneficial feature of this disclosure is a mapping of the states to a form convenient for error correction, which is described below.

The encoding scheme, along with the CCRO 800 and the sampling register 801, are shown in figure 8. The sampled phase output from the CCRO 800 is processed by a selective inversion block 802 which inverts a certain set of bits in a sampled matrix such that the output is a cyclic unary code for the set of valid CCRO 800 states. In particular, the sampled matrix may be a matrix obtained by sampling the logic values at the nodes of the CCRO at a sampling instance or a sampling stage. The apparatus, i.e. the TDC in this example includes a processing circuitry may be configured to invert selectively a set of bits in the matrix based on a predefined reference node of the sub-gate-delay resolution arrangement. According to an implementation, this inversion operation, provides a unary code with redundant non-unique mapping to the phase of the CCRO. In other words, the codes used for the phase in the range 0 to 180 degrees may, for instance, also be used for the phase in the range 180 to 360 degrees as well. The unary code may be compressed by computing the sum of non-zero bits in the code. The resulting sum, which could be seen as an example of the mapping referred to in the previous paragraph, may be unfolded by using a value of a chosen bit to obtain a non-redundant unique mapping between the code and the phase of the CCRO. Unfolding is performed by either considering the sum of non-zero bits or its inverse depending on the value of the reference bit. Here, inverse of the sum refers to the difference between the sum and the maximum possible value for the sum.

The unary code is then compressed by a ones-counter block 803 which computes the sum of all ones in the output. However, the output from the ones-counter 803 does not provide a unique mapping of the CCRO 800 phases. This can be mitigated by unfolding 804 the mapping using the value of a chosen bit of the output from the ones counter. The details of the mapping are illustrated below with the example of the 5×3 CCRO of figure 3 for a mode where $\psi = 120°$.

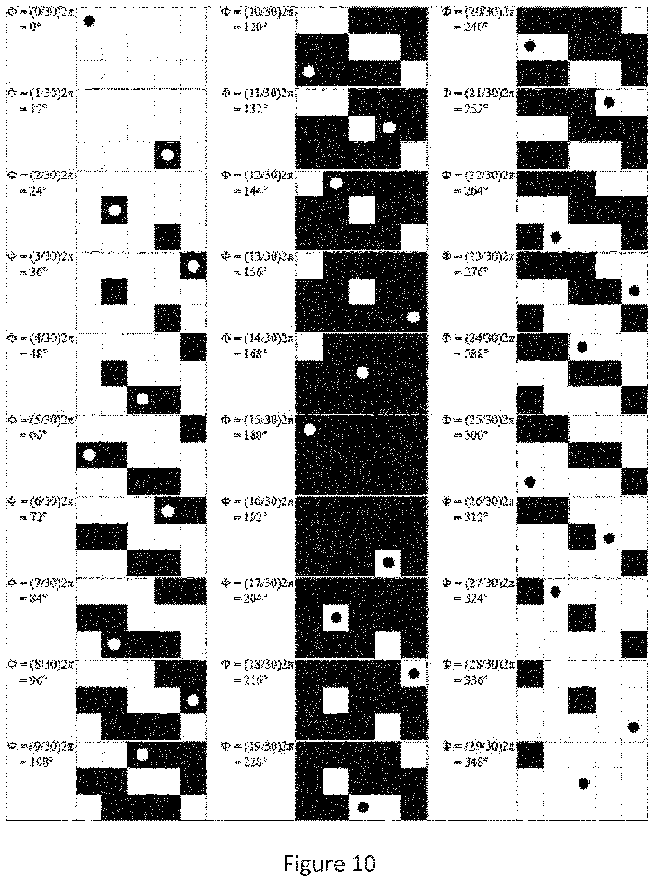

The inversion pattern to be applied on the sampled CCRO output to obtain a cyclic unary code depends on the mode of oscillation. The pattern can be illustrated as a cascade of a chess-board pattern followed by a mode-dependent inversion pattern (indicated as mode-dependent pattern in figure 9). While figure 9 shows an example of a possible choice for a chess board pattern, any chess-board pattern seen at the CCRO output (which can correspond to any arbitrary phase) may be used as the reference pattern. The mode-dependent inversion pattern is defined based on the mode of oscillation of the CCRO. For example, the example shown in figure 10 corresponds to the mode with $\psi = 120°$ as mentioned above. When the mode-dependent pattern is applied to the chess-board pattern a white cell in the mode-dependent inversion pattern causes a cell in the chess board to change state (i.e. from white/high to black/low in the example of figure 7). This general concept is shown in figure 9. The unary code obtained by applying such an inversion pattern to the CCRO phases shown in figure 7 is shown in figure 10. A white cell indicates an inversion and a black cell indicates non-inversion. Such patterns can be computed for any mode of a CCRO using the values of $\theta$ and $\psi$.

The output of the Inversion block 802 after applying the inversion pattern shown in figure 9 to the states shown in Fig. 6 is shown in Fig. 10. As it can be seen, a ones-counter operating on the pattern produces a non-unique mapping which can be unfolded based on the value of a predetermined reference bit.

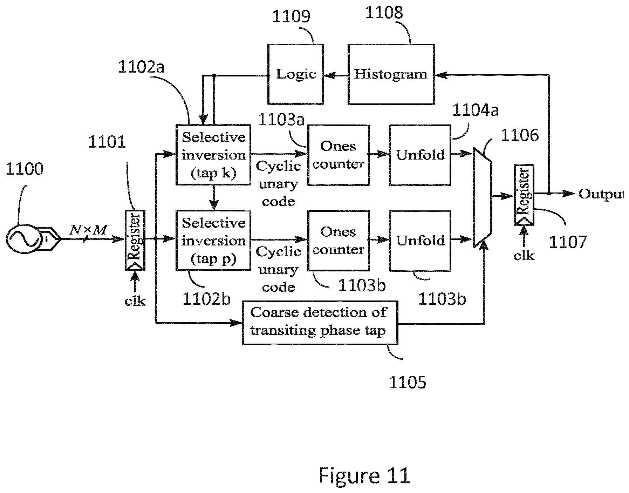

In figure 11 an encoding arrangement is disclosed. The encoding arrangement applies similar principles with the simpler example of Figure 8. A CCRO 1100 and the sampling register 1101, are shown in figure 8. The sampled phase output from the CCRO 1100 is processed by a selective inversion blocks 1102a and 1102b, respectively for different taps, which invert a certain set of bits in the sampled matrix such that the output is a cyclic unary code for the set of valid CCRO 1100 states. The unary code is then compressed by ones-counter blocks 1103a and 1103b, which compute the sum of all ones in the output. However, the outputs from the ones-counters 1103a and 1103b do not provide a unique mapping of the CCRO 1100 phases according to the respective taps. This can be mitigated by unfolding 1104a and 1104b the mapping using the value of a chosen bit of the output from the respective ones-counter.

The unfolding operation, 1104a and 1104b, which gives emphasis to the accuracy of sampling one chosen phase tap, can degrade the error-suppression capability of the encoding described above. That is, when the phase tap of the CCRO transiting at the sampling instance is in the (temporal) proximity of the reference tap, there can be large errors. This can be solved by using two such encoders with two different reference phase taps positioned maximally away from each other (temporally) so that the output from one of the encoders is always error-free. The correct output can be chosen 1106 based on a coarse estimation 1105 of the (temporal) position of the transiting phase taps at sampling instance. The chosen output is then provided to the register 1107.

Further, it is possible to detect if an appropriate inversion pattern specific to the mode of oscillation is applied by observing the histogram 1108 of the encoder output. If the inversion is correct, the output covers all the possible output codes with about equal probability for a phase input with uniform distribution while other pattern from the super-set of all inversion patterns for the CCRO results in the output hitting only a few codes. This property can be used to implement an adaptive system 1109 which selects a suitable inversion pattern by automatically detecting the mode of oscillation of the CCRO by observing the encoder output without the need of any calibrating signal (blind detection).

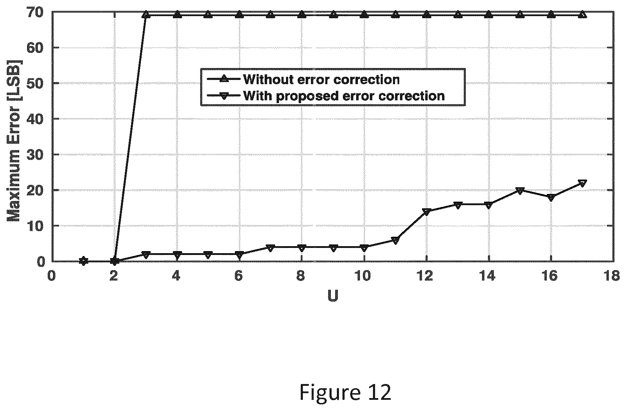

Figure 12 shows the error suppression capability of the proposed scheme. Figure 12 plots the maximum error in encoding as a function of U (the number of phase taps over which random reordering occur) for a $7 \times 5$ CCRO. It can be seen that the proposed scheme maintains a significantly low maximum error in encoding across a wide range of U compared to the case with no error correction employed.

The arrangements disclosed above reduce the dependence of performance on component and layout accuracy in data converters and delay measurement circuits that employ a CCRO as a time-domain sub-gate-delay quantizer. The arrangements thus enable the design of high-performance high-bandwidth data converters in deeply-scaled semiconductor technologies where delay mismatch resulting from layout inaccuracy is difficult to control.

The above described arrangements may be used in several different applications of which some examples are given in below. The examples are provided for better understanding of wide range of applications where the arrangements may be used.

Arrangements disclosed above are useful in high-performance time-domain ADCs, The arrangements help realizing high-resolution high-bandwidth time-domain ADCs by enabling fast and high-resolution time-to-digital conversion.

One approach to realize receiver front-ends for 5G uses an RF-digitizing approach, using a high performance ADC. The required converter with a very high bandwidth as well as a high resolution is proposed to be realized with a time-interleaved architecture where individual converters are implemented with the time-domain approach to take advantage of the superior time resolution of the advanced processes. The arrangements help realizing such converters circumventing the limitations of the earlier solutions.

All-digital phase-locked loop is gaining popularity as an attractive architecture to implement frequency synthesizers and similar applications in highly-scaled semiconductor technologies. The resolution and conversion speed of the TDC block in an ADPLL is crucial in determining the performance and bandwidth of the circuit. The arrangements disclosed above can be useful in mitigating the performance limitations of ADPLLs and frequency synthesizers designed in modern semiconductor technologies by enabling fast and high-resolution time-to-digital conversion. Phase-locked loops and frequency synthesizers are used extensively in radio transceivers and high-speed serial communication transceivers.

The arrangements can also be useful in realizing high-precision time measurement required in time-of-flight (T-o-F) sensors. Time-of-flight sensors are used in a wide range of radar applications including automotive radar and other consumer electronic radar applications.

As explained above, the arrangements using encoding a sampled phase signal as described above may be implemented in hardware, such as a mobile telephone, tablet computer, computer, telecommunication network base station or any other network connected device, or as a method. The method may be implemented as a computer program. The computer program is then executed in a computing device.

The apparatus, such as apparatus for transmitting signals in a communication network, is configured to perform one of the methods described above. The apparatus comprises necessary hardware components. These may include at least one processor, at least one memory, at least one network connection, a bus and similar. Instead of dedicated hardware components it is possible to share, for example, memories or processors with other components or access at a cloud service, centralized computing unit or other resource that can be used over a network connection.

The apparatus for transmitting signals in a communication network and the corresponding method have been described in conjunction with various embodiments herein.

However, the scope of the invention is defined by the appended set of claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems.

## Claims

1. An apparatus for encoding a sampled phase signal:

   a sampling instance configured to receive an input (100) from a sub-gate-delay resolution grid arrangement;
   a processing circuitry configured to:

   invert a set of bits in a sampled matrix sampled at the sampling instance based on an inversion pattern and a first predefined reference node of the sub-gate-delay resolution grid arrangement in order to provide a unary code with redundant non-unique mapping to the phase of the sub-gate-delay resolution grid arrangement;
   compress the unary code;
   unfold a mapping based on the compressed unary code using a value of a chosen bit to obtain a non-redundant unique mapping between the code and the phase of the sub-gate-delay resolution grid arrangement; and

   an output configured to provide an output (104) based on said unfolding,
   wherein the processing circuitry is further configured, when compressing the unary code, to count the number of ones in the unary code,
   wherein the value of a chosen bit is selected from a result of counting the number of ones in the unary code, and
   wherein the apparatus further comprises a logic and is further configured to provide a histogram of the output to the logic and to detect if an appropriate inversion pattern specific to a mode of oscillation of the sub-gate-delay resolution grid arrangement is applied.

2. An apparatus according to claim 1, wherein the apparatus comprises a second processing circuitry and a second output configured perform the same tasks with the first processing circuitry and first output in parallel with at least two different predefined reference nodes for providing at least two outputs from one input.

3. An apparatus according to claim 2, wherein the apparatus is configured to select a second predefined reference, the second predefined reference being non-contiguous to the first predefined reference in the sub-gate-delay resolution grid arrangement.

4. An apparatus according to claims 2 or 3, wherein the first and second processing circuitry are configured to estimate the temporal position of the transiting phase taps at the sampling instance.

5. An apparatus according to claim 4, wherein the first and second processing circuitry are configured to select a correct output from the at least two outputs based on the estimation.

6. An apparatus according to claim 1, wherein the apparatus is further configured to select a suitable inversion pattern by detecting the mode of oscillation.

7. A method for encoding a sampled phase signal:

   receiving an input (100) from a sub-gate-delay resolution grid arrangement at a sampling instance;
   inverting selectively a set of bits in a sampled matrix sampled at the sampling instance based on an inversion pattern and a first predefined reference node of the sub-gate-delay resolution grid arrangement in order to provide a unary code with redundant non-unique mapping to the phase of the sub-gate-delay resolution grid arrangement;
   compressing the unary code;
   unfolding a mapping based on the compressed unary code using a value of a chosen bit to obtain a non-redundant unique mapping between the code and the phase of the sub-gate-delay resolution grid arrangement;
   providing an output (104) based on said unfolding,
   wherein the compressing the unary code comprises counting the number of ones in the unary code, and

wherein the value of a chosen bit is selected from a result of counting the number of ones in the unary code,

the method further comprising providing a histogram of the output to a logic and detecting if an appropriate inversion pattern specific to a mode of oscillation of the sub-gate-delay resolution grid arrangement is applied.

8. A method according to claim 7, wherein the method is performed at least twice in parallel with at least two different predefined reference nodes for providing at least two outputs from one input.

9. A method according to claim 8, wherein the method further comprises selecting a second predefined reference so that are located in spaced apart in the sub-gate-delay resolution grid arrangement.

10. A method according to claims 8 or 9, wherein the method further comprises estimating the temporal position of the transiting phase taps at the sampling instance.

11. A method according to claim 10, the method further comprising selecting a correct output from the at least two outputs based on the estimation.

12. A method according to claim 11, wherein the method further comprises selecting a suitable inversion pattern by detecting the mode of oscillation.

13. A method according to any of preceding claims 7-12, wherein the method further comprises selecting mode of oscillation.

14. Computer program comprising computer program code, wherein the computer program code is configured to cause performing a method according to any of preceding claims 7-13, when the computer program code is executed in a computing device.

**Patentansprüche**

1. Einrichtung zum Codieren eines abgetasteten Phasensignals:

eine Abtastinstanz, die eingerichtet ist, um eine Eingabe (100) aus einer Sub-Gatterverzögerungs-Auflösungsgitteranordnung zu empfangen;

einen Verarbeitungsschaltkomplex, der eingerichtet ist, um:

einen Satz von Bits in einer abgetasteten Matrix, die an der Abtastinstanz abgetastet wird, auf Grundlage eines Inversionsmusters und eines ersten vordefinierten Referenzknotens der Sub-Gatterverzögerungs-Auflösungsgitteranordnung zu invertieren, um einen unären Code mit redundanter nicht eindeutiger Abbildung auf die Phase der Sub-Gatterverzögerungs-Auflösungsgitteranordnung bereitzustellen;

den unären Code zu komprimieren;

eine Abbildung auf Grundlage des komprimierten unären Codes unter Verwendung eines Werts eines gewählten Bits zu entfalten, um eine nicht redundante eindeutige Abbildung zwischen dem Code und der Phase der Sub-Gatterverzögerungs-Auflösungsgitteranordnung zu erlangen; und

einen Ausgang, der eingerichtet ist, um eine Ausgabe (104) auf Grundlage des Entfaltens bereitzustellen,

wobei der Verarbeitungsschaltkomplex weiterhin eingerichtet ist, um beim Komprimieren des unären Codes die Anzahl von Einsen in dem unären Code zu zählen,

wobei der Wert eines gewählten Bits aus einem Ergebnis des Zählens der Anzahl von Einsen in dem unären Code ausgewählt wird und

wobei die Einrichtung weiterhin eine Logik umfasst und weiterhin eingerichtet ist, um ein Histogramm der Ausgabe an die Logik bereitzustellen und zu detektieren, ob ein geeignetes Inversionsmuster angewendet wird, das für einen Schwingungsmodus der Sub-Gatterverzögerungs-Auflösungsgitteranordnung spezifisch ist.

2. Einrichtung nach Anspruch 1, wobei die Einrichtung einen zweiten Verarbeitungsschaltkomplex und einen zweiten Ausgang umfasst, der eingerichtet ist, um die gleichen Aufgaben mit dem ersten Verarbeitungsschaltkomplex und dem ersten Ausgang parallel mit mindestens zwei verschiedenen vordefinierten Referenzknoten durchzuführen, um mindestens zwei Ausgaben aus einer Eingabe bereitzustellen.

3. Einrichtung nach Anspruch 2, wobei die Einrichtung eingerichtet ist, um eine zweite vordefinierte Referenz auszuwählen, wobei die zweite vordefinierte Referenz nicht zusammenhängend mit der ersten vordefinierten Referenz in der Sub-Gatterverzögerungs-Auflösungsgitteranordnung ist.

4. Vorrichtung nach den Ansprüchen 2 oder 3, wobei der erste und der zweite Verarbeitungsschaltkomplex eingerichtet sind, um die zeitliche Position der Übergangsphasenabgriffe an der Abtastinstanz abzuschätzen.

**5.** Vorrichtung nach Anspruch 4, wobei der erste und der zweite Verarbeitungsschaltkomplex eingerichtet sind, um eine korrekte Ausgabe aus den mindestens zwei Ausgaben auf der Grundlage der Abschätzung auszuwählen.

**6.** Einrichtung nach Anspruch 1, wobei die Einrichtung weiterhin eingerichtet ist, um ein geeignetes Inversionsmuster durch Detektieren des Schwingungsmodus auszuwählen.

**7.** Verfahren zum Codieren eines abgetasteten Phasensignals:

Empfangen einer Eingabe (100) aus einer Sub-Gatterverzögerungs-Auflösungsgitteranordnung an einer Abtastinstanz;
selektives Invertieren eines Satzes von Bits in einer abgetasteten Matrix, die an der Abtastinstanz abgetastet wird, auf Grundlage eines Inversionsmusters und eines ersten vordefinierten Referenzknotens der Sub-Gatterverzögerungs-Auflösungsgitteranordnung, um einen unären Code mit redundanter nicht eindeutiger Abbildung auf die Phase der Sub-Gatterverzögerungs-Auflösungsgitteranordnung bereitzustellen;
Komprimieren des unären Codes;
Entfalten einer Abbildung auf Grundlage des komprimierten unären Codes unter Verwendung eines Werts eines gewählten Bits, um eine nicht redundante eindeutige Abbildung zwischen dem Code und der Phase der Sub-Gatterverzögerungs-Auflösungsgitteranordnung zu erlangen;
Bereitstellen einer Ausgabe (104) auf Grundlage des Entfaltens,
wobei das Komprimieren des unären Codes Zählen der Anzahl von Einsen in dem unären Code umfasst und
wobei der Wert eines gewählten Bits aus einem Ergebnis des Zählens der Anzahl von Einsen in dem unären Code ausgewählt wird,
das Verfahren weiterhin Bereitstellen eines Histogramms der Ausgabe an eine Logik und Detektieren umfasst, ob ein geeignetes Inversionsmuster angewendet wird, das für einen Schwingungsmodus der Sub-Gatterverzögerungs-Auflösungsgitteranordnung spezifisch ist.

**8.** Verfahren nach Anspruch 7, wobei das Verfahren mindestens zweimal parallel mit mindestens zwei verschiedenen vordefinierten Referenzknoten durchgeführt wird, um mindestens zwei Ausgaben aus einer Eingabe bereitzustellen.

**9.** Verfahren nach Anspruch 8, wobei das Verfahren weiterhin Auswählen einer zweiten vordefinierten Referenz umfasst, so dass sie in der Sub-Gatterverzögerungs-Auflösungsgitteranordnung beabstandet angeordnet sind.

**10.** Verfahren nach den Ansprüchen 8 oder 9, wobei das Verfahren weiterhin Abschätzen der zeitlichen Position der Übergangsphasenabgriffe an der Abtastinstanz umfasst.

**11.** Verfahren nach Anspruch 10, das Verfahren weiterhin umfassend Auswählen einer korrekten Ausgabe aus den mindestens zwei Ausgaben auf der Grundlage der Abschätzung.

**12.** Verfahren nach Anspruch 11, wobei das Verfahren weiterhin Auswählen eines geeigneten Inversionsmusters durch Detektieren des Schwingungsmodus umfasst.

**13.** Verfahren nach einem der vorhergehenden Ansprüche 7 bis 12, wobei das Verfahren weiterhin Auswählen eines Schwingungsmodus umfasst.

**14.** Computerprogramm, umfassend Computerprogrammcode, wobei der Computerprogrammcode eingerichtet ist, um Durchführen eines Verfahrens nach einem der vorhergehenden Ansprüche 7 bis 13 zu bewirken, wenn der Computerprogrammcode in einer Datenverarbeitungsvorrichtung ausgeführt wird.

**Revendications**

**1.** Appareil de codage d'un signal de phase échantillonné :

une instance d'échantillonnage configurée pour recevoir une entrée (100) en provenance d'un agencement de grille de résolution inférieure au délai de porte ;
une circuiterie de traitement configurée pour :

inverser un ensemble de bits dans une matrice échantillonnée échantillonnée au niveau de l'instance d'échantillonnage sur la base d'un motif d'inversion et d'un premier nœud de référence prédéfini de l'agencement de grille de résolution inférieure au délai de porte afin de fournir un code unaire avec un mappage non unique redondant à la phase de l'agencement de grille de résolution inférieure au délai de porte ;
compresser le code unaire ;
révéler un mappage sur la base du code unaire compressé à l'aide d'une valeur d'un bit choisi pour obtenir un mappage unique non redondant entre le code et la phase de l'agencement de grille de résolution inférieure au délai de porte ; et

une sortie configurée pour fournir une sortie (104) sur la base de ladite révélation,

dans lequel la circuiterie de traitement est en outre configurée, lors de la compression du code unaire, pour compter le nombre de uns dans le code unaire,

dans lequel la valeur d'un bit choisi est sélectionnée parmi un résultat de comptage du nombre de uns dans le code unaire, et l'appareil comprenant en outre une logique et étant en outre configuré pour fournir un histogramme de la sortie à la logique et pour détecter si un motif d'inversion approprié spécifique à un mode d'oscillation de l'agencement de grille de résolution inférieure au délai de porte est appliqué.

2. Appareil selon la revendication 1, l'appareil comprenant une deuxième circuiterie de traitement et une deuxième sortie configurées pour réaliser les mêmes tâches avec la première circuiterie de traitement et la première sortie en parallèle avec au moins deux nœuds de référence prédéfinis différents pour fournir au moins deux sorties à partir d'une entrée.

3. Appareil selon la revendication 2, l'appareil étant configuré pour sélectionner une deuxième référence prédéfinie, la deuxième référence prédéfinie étant non contiguë à la première référence prédéfinie dans l'agencement de grille de résolution inférieure au délai de porte.

4. Appareil selon les revendications 2 ou 3, dans lequel les première et deuxième circuiteries de traitement sont configurées pour estimer la position temporelle des prises de phase de transition au niveau de l'instance d'échantillonnage.

5. Appareil selon la revendication 4, dans lequel les première et deuxième circuiteries de traitement sont configurées pour sélectionner une sortie correcte parmi les au moins deux sorties sur la base de l'estimation.

6. Appareil selon la revendication 1, l'appareil étant en outre configuré pour sélectionner un motif d'inversion approprié par détection du mode d'oscillation.

7. Procédé de codage d'un signal de phase échantillonné :

réception d'une entrée (100) en provenance d'un agencement de grille de résolution inférieure au délai de porte au niveau d'une instance d'échantillonnage ;

inversion sélective d'un ensemble de bits dans une matrice échantillonnée échantillonnée au niveau de l'instance d'échantillonnage sur la base d'un motif d'inversion et d'un premier nœud de référence prédéfini de l'agencement de grille de résolution inférieure au délai de porte afin de fournir un code unaire avec un mappage non unique redondant à la phase de l'agencement de grille de résolution inférieure au délai de porte ;

compression du code unaire ;

révélation d'un mappage sur la base du code unaire compressé à l'aide d'une valeur d'un bit choisi pour obtenir un mappage unique non redondant entre le code et la phase de l'agencement de grille de résolution inférieure au délai de porte ;

fourniture d'une sortie (104) sur la base de ladite révélation,

dans lequel la compression du code unaire comprend le comptage du nombre de uns dans le code unaire, et

dans lequel la valeur d'un bit choisi est sélectionnée parmi un résultat de comptage du nombre de uns dans le code unaire,

le procédé comprenant en outre la fourniture d'un histogramme de la sortie à une logique et la détection de si un motif d'inversion approprié spécifique à un mode d'oscillation de l'agencement de grille de résolution inférieure au délai de porte est appliqué.

8. Procédé selon la revendication 7, le procédé étant réalisé au moins deux fois en parallèle avec au moins deux nœuds de référence prédéfinis différents pour fournir au moins deux sorties à partir d'une entrée.

9. Procédé selon la revendication 8, le procédé comprenant en outre la sélection d'une deuxième référence prédéfinie de sorte à être située de manière espacée dans l'agencement de grille de résolution inférieure au délai de porte.

10. Procédé selon les revendications 8 ou 9, le procédé comprenant en outre l'estimation de la position temporelle des prises de phase de transition au niveau de l'instance d'échantillonnage.

11. Procédé selon la revendication 10, le procédé comprenant en outre la sélection d'une sortie correcte parmi les au moins deux sorties sur la base de l'estimation.

12. Procédé selon la revendication 11, le procédé comprenant en outre la sélection d'un motif d'inversion approprié par détection du mode d'oscillation.

13. Procédé selon l'une quelconque des revendications précédentes 7 à 12, le procédé comprenant en outre la sélection d'un mode d'oscillation.

14. Programme informatique comprenant un code de programme informatique, le code de programme informatique étant configuré pour provoquer la réalisation d'un procédé selon l'une quelconque des revendications précédentes 7 à 13, lorsque le code de programme informatique est exécuté dans un dispositif informatique.

Figure 1

Figure 2

Figure 3

Figure 4

Figure 5

Figure 6

Figure 8

Chess-board pattern   Mode-dependent pattern   Selective inversion

Figure 9

Figure 7

Figure 10

Figure 11

Figure 12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2012154187 A1

- US 2012319883 A1

### Non-patent literature cited in the description

- Stochastic TDC architecture with self-calibration. **SATOSHI ITO et al.** CIRCUITS AND SYSTEMS (APCCAS), 2010 IEEE ASIA PACIFIC CONFERENCE ON. IEEE, 06 December 2010, 1027-1030
- Time-to-digital converter with 3-ps resolution and digital linearization algorithm. **ZANUSO M et al.** ESSCIRC, 2010 PROCEEDINGS OF THE. IEEE, 14 September 2010, 262-265

- Mitigation of Sampling Errors in VCO-Based ADCs. **UNNIKRISHNAN VISHNU et al.** IEEE TRANSACTIONS ON CIRCUITS AND SYSTEMS I: REGULAR PAPERS. IEEE, 01 July 2017, vol. 64, 1730-1739